# EUROPEAN PATENT SPECIFICATION

(11) **EP 0 313 814 B1**
(45) Date of publication and mention of the grant of the patent: **07.12.1994**
(21) Application number: 88115530.3
(22) Date of filing: 22.09.1988
(51) Int. Cl.: H01L 21/31, H01L 21/312

(54) **Organic sidewall structures**
Flankenstruktur aus organischem Material
Structures de flancs en matière organique

(30) Priority: 30.10.1987 US 114960
(43) Date of publication of application: 03.05.1989
(73) Proprietor: International Business Machines Corporation, Armonk, N.Y. 10504 (US)
(72) Inventor: Cote, William J., Essex Junction Vermont 05452 (US); Kerbaugh, Michael L., Burlington Vermont 05401 (US); Kenney, Donald M., Shelburne Vermont 05482 (US); Leach, Michael A., Winooski Vermont 05404 (US); Robinson, Jeffrey A., Essex Junction Vermont 05452 (US); Sweetser, Robert W., Essex Junction Vermont 05452 (US)
(74) Representative: Schäfer, Wolfgang, Dipl.-Ing.

(56) References cited:
- EP-A- 0 111 086
- GB-A- 2 003 660
- PATENT ABSTRACTS OF JAPAN, vol. 11, no. 319 (P-627)(2766), 17 October 1987 ; & JP-A-62106456
- PATENT ABSTRACTS OF JAPAN, vol. 9, no. 15 (E-291)(1738), 22 January 1985 ; & JP-A-59163829
- IBM TECHNICAL DISCLOSURE BULLETIN, vol. 25, no. 11A, April 1983, pages 5538-5540, New York, US ; K.R. GREBE et al. : "Para-Xylylene patterning".
- PATENT ABSTRACTS OF JAPAN, vol. 11, no. 275 (E-537), 5 September 1987 ; & JP-A-62073633
- EXTENDED ABSTRACTS, volume 82-2, October 1982, page 243, Pennington, New Jersey, US ; E. KINSBRON et al. : "Detection and Removal of Sidewall Buildup on Tri-Level Structures".
- IBM TECHNICAL DISCLOSURE BULLETIN, volume 27, no. 10A, March 1985, pages 5493, 5494, New York, US ; "Polyimide profile control by dry etching".

## Description

Reference is made to U.S. Patent 4 707 218, entitled "Lithographic Image Size Reduction," and assigned to the assignee of the invention. The application relates to the general idea of using inorganic conformal layers to define sidewall spacers on vertically-imaged photoresist. The spacers define images having an area less than the images normally printed by the photolithographic exposure system.

Over the past several years, many different methods have been proposed in the integrated circuit processing art for forming sub-micron images. Most of these methods rely on state-of-the-art photolithographic tooling. Other methods rely on more exotic exposure systems (e.g., X-ray, E-beam, etc.). Whichever of the above exposure systems are used, its source intensity, beam focus, and other parameters combine to establish a minimum feature size that can be reliably printed.

Recently, efforts have been made to extend the useful life of optical tooling that produces images that are too large for present-day applications. One method of supplementing these minimum images is by the use of sidewall structures. In this technology, a conformal layer is coated on a "mandrel," which is a block of material typically having substantially vertical sidewalls. The conformal layer is then etched in an anisotropic mode, so that portions thereof laying on horizontal surfaces (e.g., the upper surface of the mandrel) are removed. Portions of the conformal layer disposed on vertical surfaces (e.g., the sidewalls of the mandrel) remain to form the sidewall spacers. In some applications, the sidewall-coated mandrels are used as a mask to define an image in underlaying layers. See an article by Varshney, entitled "Self-Aligned VMOS Structure Using Reactive Ion Etching," IBM Technical Disclosure Bulletin, Vol. 22, No. 8, January 1980, pp. 3705-3706, wherein an oxide mandrel is coated with a conformal oxide layer that is etched to define oxide spacers, the mandrel-spacer composite defining an image in underlaying silicon layers. In other applications, the mandrel is removed, without removing the spacers, and the spacers define an image. See e.g, U.S.-A- 4,502,914 entitled "Method of Making Structures with Dimensions in the Submicrometer Range," and assigned to the assignee of the present invention. A conformal layer of silicon oxide or silicon nitride is coated on a polymeric mandrel. After spacers are defined on the sidewalls of the mandrel, the mandrel is removed and the spacers serve as masks to etch deep trenches in the underlaying silicon substrate.

As shown by the above references, the respective compositions of the conformal layer and the mandrel are determined by the particular masking application of the resulting structure. In applications in which the mandrel-spacer combination serves as a mask, both materials must be resistant to the etchant that patterns the underlaying layers. In applications in which only the spacer is used as a mask, the mandrel must be made of a material that can be etched without appreciably attacking the spacers.

The above references utilize silicon oxide and silicon nitride as the conformal layers that define the sidewall spacers. Both of these materials are typically deposited at temperatures of 175°C and above. Organic mandrel structures (e.g., photoresist) may begin to reflow at these high deposition temperatures. Moreover, when these layers are deposited on oxide or nitride passivation layers, such layers may be etched during definition of the spacers. In the above-referenced U.S.-A- 4 707 218, this shortcoming was addressed by incorporating an etch-stop layer on the passivation layer.

Accordingly, it would be advantageous to use the same mandrel-spacer combination for each of the above applications, while avoiding the high deposition temperatures and overetch problems attendant with conventional conformal layers.

It is thus an object of the present invention to provide a process for supplementing the photolithographic limits of image exposure tools.

It is another object of the invention to provide a mandrel-spacer combination that can be used in a plurality of patterning applications.

It is another object of the invention to provide spacers on organic mandrels without exposing the mandrels to high processing temperatures.

These and other objects of the invention are realized by a method for defining a masking structure on a substrate, comprising the steps of:
Defining a plurality of organic mandrels having substantially vertical sidewalls on the substrate;
depositing at room temperature a conformal layer of parylene on the substrate and said mandrels; and
anisotropically etching said layer of parylene so as to define spacers on said sidewalls of said mandrels,
said spacers and said mandrels being exposed to dry etchants in which they have analogous etch rates or to wet etchants in which they have differing etch rates.

The resulting mandrel-spacer pair is compatible with a plurality of patterning applications.

That is, the mandrel spacer combination can be used as a composite mask, or the mandrel may be removed without appreciably removing the organic spacers such that the spacers alone can serve as a mask. The organic layer may be patterned without appreciably etching underlaying passivation layers.

The foregoing and other structures and teachings of the present invention will become more apparent upon a description of the best mode for carrying out the invention as rendered below. In the description to follow, reference will be made to the accompanying Drawing, in which:
- Figs. 1-2: are cross-sectional views of a substrate undergoing the process steps of the invention;
- Fig. 3: is a cross-sectional view of a substrate undergoing a process in accordance with a first embodiment of the invention;
- Fig. 4: is a cross-sectional view of a substrate undergoing a process in accordance with a second embodiment of the invention; and
- Fig. 5: is a cross-sectional view of a substrate undergoing a process in accordance with a third embodiment of the invention.

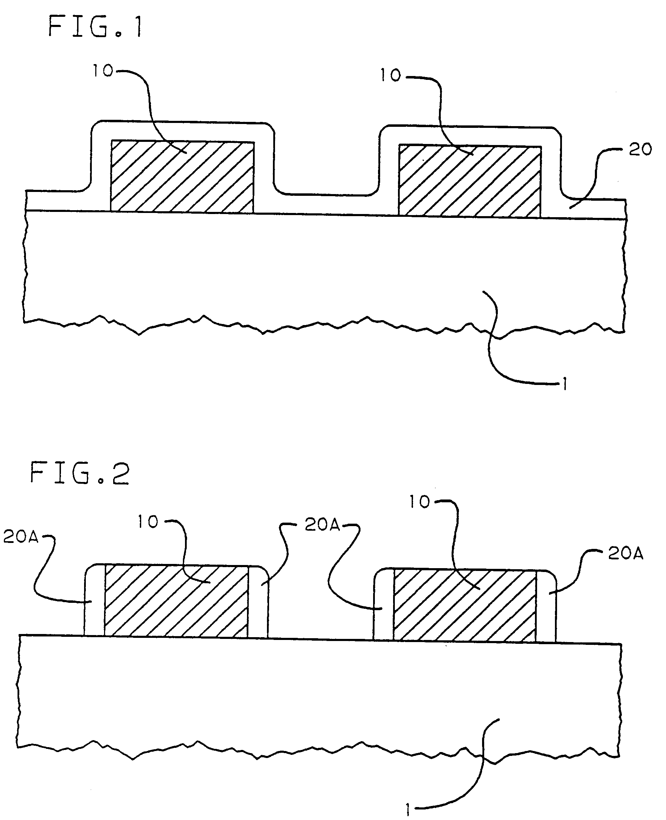

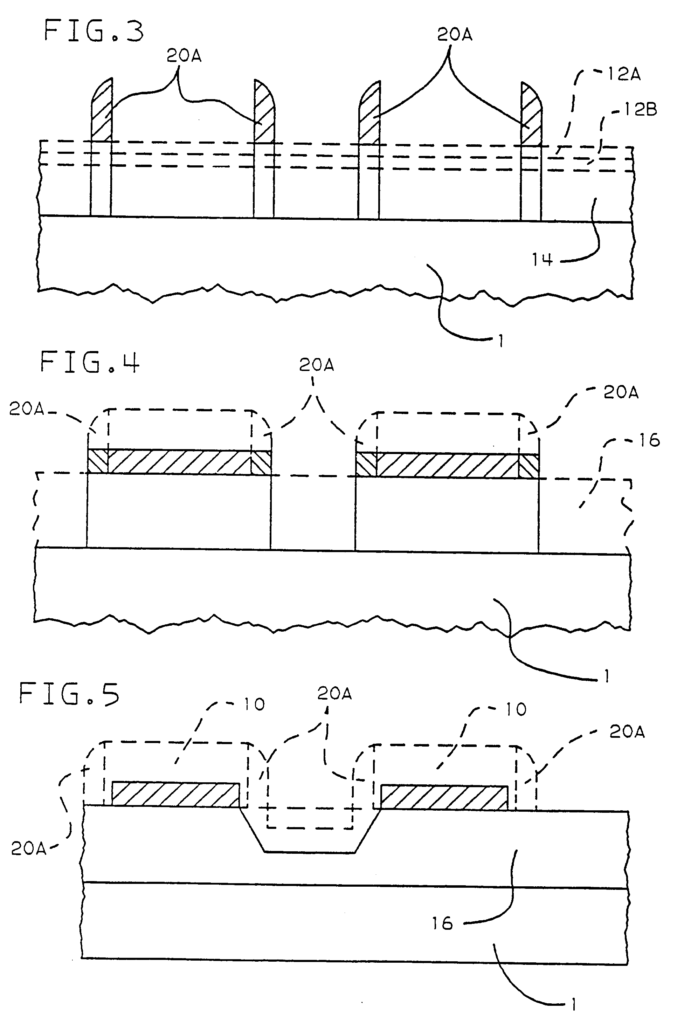

As shown in Fig. 1, a conformal organic layer 20 is coated on mandrels 10 formed on a substrate 1. The substrate 1 is shown as being a single block of material for ease of illustration. As shown in Figs. 3-5, the process of the invention can be carried out on a semiconductor or insulator substrate having one or more conductive, semiconductive, and/or insulative layers disposed on its upper surface. The mandrels 10 are formed from an organic resinous material. For example, any commercially available polyimide (e.g., "PI 2555," available from the DuPont Corp. of Wilmington, Delaware) could be used. Alternatively, any commercially available photosensitive polymer (e.g., "AZ 1350J" sold by AZ Photoresist Products Group of American Hoechst Corp. Summerville, New Jersey, "AZ 135OJ" being a trademark of American Hoechst Corp.) could be used. If polyimides are used, a blanket layer of polyimide is deposited and is imagewise exposed through a patterned photoresist layer. The exposed portions of the polyimide layer are then removed by exposure to an anisotropic O₂ gaseous plasma. However, as will be described in more detail below, it is preferred to use a photosensitive polymer to provide the mandrel structures.

The conformal organic layer is poly-p-xylylene, or "parylene." In carrying out the experiments associated with the invention, parylene was deposited using the following process. The wafers were vertically oriented within a conventional tube reactor, so that the di-p-xylylene gas flow was perpendicular to the wafers and centered within the reactor. The reactor pressure was maintained at 66.5 µbar (50 mTorr) (1 µbar = 10⁻¹ Pa). In order to minimize turbulence within the reactor, the gas outlet valve was maintained at its minimum "open" setting. In practice, parylene layers of up to 0.7 µm in thickness have been conformally coated at room temperature on 1.6 micrometer mandrels having sidewall slopes of greater than 80°.

Parylene presents several beneficial materials characteristics. Because parylene is deposited at room temperature and because the subsequent etch steps are also carried out at low temperature, there is no need to "harden" the photoresist mandrels 10 by exposure to a 200°C-250°C heating step as required in the aforementioned U.S.-A- 4 707 218.

Moreover, parylene is more conformal (on the order of 95% conformality) than the silicon oxide and silicon nitride layers used in the prior art. The parylene deposition is a surface rate limited reaction, which by its very nature is a highly conformal process.

As shown in Fig. 2, the organic parylene layer 20 is then anisotropically etched to provide spacers 20A on the sidewalls of the mandrels 10. Spacers 20A are defined by anisotropically etching the parylene layer 20 in an anisotropic O₂ gaseous plasma. The plasma is held at conventional anisotropic reactive ion etch conditions (e.g., less than 13.3 to 26.6 µbar (10-20 milliTorr) pressure and approximately 400 volts DC). During the course of this anisotropic etch, upper portions of the mandrels 10 may also be eroded. However, because the thickness of the mandrels is typically much greater than the thickness of the conformal layer, some etching of the mandrels may occur without deleteriously affecting the operation of the invention. Moreover, since neither oxides nor nitrides are appreciably etched in O₂ plasmas, there is no need to protect underlaying oxide and/or nitride passivation layers by interposing an etch-stop.

It has been found that the resulting above-described organic mandrel-organic spacer combination presents a series of etch characteristics that can be used in a variety of patterning applications. Several of these pattern applications will now be discussed.

Fig. 3 shows a first patterning method utilizing the mandrel-spacer combination of the present invention. In this process, a plurality of conductive lines are defined from a layer of conductive material 14 disposed on the substrate 1. Etch-stop layers 12A, 12B are disposed on the conductive layer 14. After formation of the mandrel-spacer pair, the mandrel is removed by exposure to an etchant that does not appreciably attack the spacers. More specifically, it has been found that N-methyl-pyrollidone (NMP) will completely remove conventional photosensitive polymers without removing the parylene spacers. Similar results were achieved using sulfuric-nitric acid, dilute KOH after blanket exposure of the photoresist and acetone. Thus, it would appear that the parylene spacers are impervious to all conventional photoresist solvents. Thus, as shown in Fig. 3, the spacers 20A remain to pattern the underlaying etch stop layers 12A, 12B. The patterned etch-stop layers subsequently serve as a mask to pattern the underlaying conductor layer 14. A more detailed description of the method of patterning the layers 12A, 12B and 14 after spacer definition is rendered in U.S.-A- 4,648,937, entitled "Method of Preventing Asymmetric Etching of Lines in Sub-Micrometer Range Sidewall Image Transfer," and assigned to the assignee of the present invention, the teachings of which are incorporated herein by reference.

Fig. 4 presents a second patterning method utilizing the organic mandrel-organic spacer combination of the present invention. In this process, apertures are formed through a thick insulating layer 16 overlying the substrate 1. The insulating layer 16 can be undoped silicon oxide, phosphosilicate glass (PSG), boro-phosphosilicate glass (BPSG), or an organic resin such as polyimide. If the insulating layer 16 is made of undoped silicon oxide or glass, it can be patterned by exposure to a 92% CF₄/8% O₂ plasma. If the insulating layer 16 is polyimide, it can be patterned in the same O₂ plasma that defines the sidewall spacers 20A. In either instance, it has been found that parylene and conventional photoresist materials have equivalent etch rates. As a consequence of this equivalent etch rate in O₂ and CF₄/O₂ plasmas, the parylene-photoresist combination can be completely removed in the same ambient. During removal of the dashed portions of insulating layer 16, equivalent portions of the mandrel 10 and spacers 20A will be removed.

Fig. 5 presents a third patterning method utilizing the organic mandrel-organic spacer combination of the present invention. Similarly to the process shown in Fig. 4, apertures are defined in an insulating layer 16. In Fig. 5 the insulating layer 16 is etched under conditions such that horizontal portions of the masking structure are removed. The resulting apertures have sloped sidewalls. After spacers 20A are defined, the substrate is subjected to a CF₄/O₂ plasma in which oxygen constitutes 40%-60% of the total gas mixture. The etch chamber is held at a pressure of 53.2 to 93.1 µbar (40-70 milliTorr). Under these conditions, the mandrel-spacer combination is horizontally eroded. Spacers 20A are completely removed during the course of the etch. As the masking structure is horizontally eroded, portions of the underlaying insulating layer 16 are exposed to the etchant for different lengths of time. Consequently, the resulting apertures have sloped sidewalls (as compared to the vertical sidewalls resulting from the etch sequence described with reference to Fig. 4). Again, the above-described process makes use of the similarities in etch rate between the parylene spacers 20A and the organic resin mandrels 10 in gaseous plasmas.

As described with reference to the processes shown in Fig. 3-5, the organic mandrel-organic spacer combination of the invention presents a plurality of characteristics not provided by other mandrel-spacer combinations of the prior art. The spacers are defined in a gaseous plasma that does not appreciably attack underlaying oxide and/or nitride layers. The mandrels can be removed by exposure to wet solvents that do not remove the spacers. The Mandrels and the spacers have equivalent etch rates in oxygen and halocarbon-based gaseous plasmas. Finally, the spacers present several beneficial materials characteristics (i.e., low deposition temperature and high conformality).

## Claims

1. Method for defining a masking structure on a substrate, comprising the steps of:
defining a plurality of organic mandrels having substantially vertical sidewalls on the substrate;
depositing a conformal organic layer on the substrate and said mandrels; and
anisotropically etching said conformal layer organic so as to define spacers on said sidewalls of said mandrels,
characterized in that said conformal organic layer consists of parylene and in that
said parylene spacers and said mandrels are exposed to dry etchants in which they have analogous etch rates or wet etchants in which they have differing etch rates.

2. Method as recited in claim 1, wherein said dry etchants comprise gaseous plasmas selected from the group consisting of oxygen plasmas and halocarbon-based plasmas.

3. Method as recited in claim 1, wherein said wet etchant is selected from the group consisting of NMP, sulfuric-nitric, KOH, and acetone.

4. Method as recited in any one of claims 1 to 3, wherein said mandrels are comprised of a photosensitive polymer or polyimide.

5. Method of providing a masking structure on a surface of a processed semiconductor substrate, comprising the steps of:
forming a mandrel of a photosensitive polymer on the surface, said mandrel having substantially horizontal and substantially vertical surfaces;
coating said mandrel with a conformal organic layer; and
anisotropically etching said conformal layer and said photosensitive polymer so that portions of said conformal layer remain on said vertical surfaces of said mandrel to form spacers thereon,
characterized in that said conformal layer is formed of parylene.

6. Method as recited in any one of claims 1 to 5, further comprising the step of:
removing said mandrels without appreciably attacking said spacers.

## Patentansprüche

1. Verfahren zum Definieren einer Maskenstruktur auf einem Substrat, das folgende Schritte umfaßt:
Definieren einer Vielzahl von organischen Stegen, die auf dem Substrat im wesentlichen vertikale Flanken haben;
Auftragen einer konformen organischen Schicht auf das Substrat und die Stege; und
anisotropes Ätzen der erwähnten konformen organischen Schicht, um auf den Flanken der Stege Abstandhalter zu definieren,
dadurch gekennzeichnet, daß die konforme organische Schicht aus Parylen besteht, und daß
die Parylen-Abstandhalter und die Stege Trockenätzmitteln, in denen sie analoge Ätzraten aufweisen, oder Naßätzmitteln, in denen sie unterschiedliche Ätzraten aufweisen, ausgesetzt werden.

2. Verfahren nach Anspruch 1, bei dem die Trockenätzmittel gasförmige Plasmen darstellen, die aus der Gruppe bestehend aus Sauerstoffplasmen und Plasmen auf Halogenkohlenstoffbasis ausgewählt wurden.

3. Verfahren nach Anspruch 1, bei dem das Naßätzmittel aus der Gruppe bestehend aus NMP, Schwefel-Salpeter-Säure, KOH und Azeton ausgewählt wurde.

4. Verfahren nach einem der Ansprüche 1 bis 3, bei dem die Stege aus einem lichtempfindlichen Polymer oder Polyimid bestehen.

5. Verfahren zur Erzeugung einer Maskenstruktur auf einer Oberfläche eines bearbeiteten Halbleitersubstrats, das folgende Schritte umfaßt:
Formung eines Stegs aus einem lichtempfindlichen Polymer auf der Oberfläche, wobei dieser Steg im wesentlichen horizontale und im wesentlichen vertikale Oberflächen aufweist;
Beschichtung dieses Stegs mit einer konformen organischen Schicht; und
anisotropes Ätzen dieser konformen Schicht und des lichtempfindlichen Polymers in einer solchen Art und Weise, daß Teile der konformen Schicht auf den vertikalen Oberflächen des Stegs verbleiben und dort Abstandhalter bilden,
dadurch gekennzeichnet, daß die konforme Schicht aus Parylen hergestellt wird.

6. Verfahren nach einem der Ansprüche 1 bis 5, das weiterhin folgenden Schritt umfaßt:
Entfernung der Stege, ohne daß die Abstandhalter merkbar angegriffen werden.

## Revendications

1. Procédé pour définir une structure de masquage sur un substrat, comprenant les étapes de:
définir une pluralité de mandrins organiques ayant des flancs sensiblement verticaux sur le substrat;
déposer une couche organique conforme sur le substrat et lesdits mandrins; et
décaper anisotropiquement ladite couche organique conforme de manière à définir des entretoises sur lesdits flancs desdits mandrins,
caractérisé en ce que ladite couche organique conforme est faite de parylène, et en ce que
lesdites entretoises de parylène et lesdits mandrins sont exposés à des décapants secs dans lesquels ils ont des cadences de décapage analogues, ou à des décapants humides dans lesquels ils ont des cadences de décapage différentes.

2. Procédé selon la revendication 1, dans lequel lesdits décapants secs sont des plasmas gazeux sélectionnés dans le groupe composé de plasmas d'oxygène et de plasmas à base d'halocarbone.

3. Procédé selon la revendication 1, dans lequel ledit décapant humide est sélectionné dans le groupe composé de NMP, d'acide sulfurique-nitrique, de KOH et d'acétone.

4. Procédé selon l'une quelconque des revendications 1 à 3, dans lequel lesdits mandrins sont constitués d'un polyimide ou d'un polymère photosensible.

5. Procédé pour définir une structure de masquage sur une surface d'un substrat semi-conducteur traité, comprenant les étapes de:
former un mandrin fait dans un polymère photosensible sur la surface, ledit mandrin ayant des surfaces sensiblement horizontales et sensiblement verticales;
revêtir ledit mandrin d'une couche organique conforme;
et
décaper anisotropiquement ladite couche conforme et ledit polymère photosensible de sorte que des portions de ladite couche conforme restent sur lesdites surfaces verticales dudit mandrin pour former des entretoises dessus,
caractérisé en ce que ladite couche conforme est faite de parylène.

6. Procédé selon l'une quelconque des revendications 1 à 5, comprenant en outre l'étape de:
enlever lesdits mandrins sans attaquer de façon appréciable lesdites entretoises.
